# EUROPEAN PATENT SPECIFICATION

(11) **EP 2 533 273 B1**
(45) Date of publication and mention of the grant of the patent: **08.02.2017**
(21) Application number: 12171200.4
(22) Date of filing: 07.06.2012
(51) Int. Cl.: C25D 17/00, H01L 21/288

(54) **An ECPR master electrode, and a method for providing such master electrode**
ECPR-Masterelektrode und Verfahren zur Bereitstellung solch einer Masterelektrode
Électrode maître ECPR et procédé permettant de fournir une telle électrode maître

(30) Priority: 07.06.2011 EP 11290261
(43) Date of publication of application: 12.12.2012
(73) Proprietor: Luxembourg Institute of Science and Technology (LIST), 4362 Esch-sur-Alzette (LU)
(72) Inventor: Chantelauze, Simon, 69410 Champagne au Mont d' Or (FR); Cuthbertson, Alan, 69410 Champagne au Mont d'Or (FR); Dainese, Matteo, 69410 Champagne au Mont d'Or, (FR); Fredenberg, Mikael, 112 45 STOCKHOLM (SE); Kennedy, Tim, 38000 GRENOBLE (FR); Laviron, Cyrille, 38700 CORENC (FR); Möller, Patrik, 112 32 STOCKHOLM (SE)
(74) Representative: Lecomte & Partners

(56) References cited:
- JP-A- 2005 256 110
- US-A1- 2004 182 716

## Description

### TITLE: AN ECPR MASTER ELECTRODE, AND A METHOD FOR PROVIDING SUCH MASTER ELECTRODE

### FIELD OF THE INVENTION

The present invention relates to an ECPR master electrode, and a method for providing such master electrode. More particularly, the present invention relates to a circular ECPR master electrode.

### BACKGROUND ART

Patent document US 2004/0182716 A1 discloses a process for selective patterning of substrates or previously formed layers using contact masks wherein the mating and/or un-mating of masks and substrates is made to occur in a non-parallel manner.

WO 02/103085 and WO 2007058603 relate to an electrochemical pattern replication process, ECPR, and the construction of a master electrode for production of appliances involving micro and nano structures using ECPR. An etching or plating pattern, which is defined by the master electrode, is replicated on an electrically conductive material, commonly denoted as a substrate. During ECPR, the master electrode is put in close contact with the substrate and the etching/plating pattern is directly transferred onto the substrate by an etching/plating process. The contact etching/plating process is performed in local etching/plating cells, which are formed in cavities between the master electrode and the substrate.

The cavities are provided as electrochemical cells having an open end at the upper surface of the master electrode, and extending downwards. Hence, the upper surface of the master electrode includes a topographical pattern defining at least one electrochemical cell, wherein the bottom of each cell is provided with an electrically conducting material. During ECPR, each cell is filled with an electrolyte solution, for allowing conducting ions of the conducting material to be transferred from the bottom of each cell to the substrate to be patterned.

The area between the electrochemical cells, i.e. the uppermost area of the topographical pattern of the master electrode is provided with an insulating layer for preventing unwanted parasitic currents during the ECPR process. Hence, ECPR will only provide pattern transfer at the positions being defined by the electrochemical cells.

Before the master electrode is used in the ECPR, the electrochemical cells need to be prefilled with a conductive material. Usually, the thickness of the prefilled material is in the range of 0,5 to 10 micrometers, depending on the specific application. During the ECPR the conductive material is transferred from the bottom of the electrochemical cells of the master electrode to the substrate being plated. Thus, when the master electrode is separated from the processed substrate the prefilled conductive material is arranged on the substrate.

The master electrode may be made of a carrier element of a durable material, since the master electrode should be used for a plurality of processes of etching or plating. One such material is Si, which allows the master electrode to be manufactured by well established and high yield semiconductor processes. Consequently, in many cases circular Si wafers form the carrier elements of ECPR master electrodes.

For the chip industry, the topographical pattern of the master electrode may be arranged in a planar distribution across the master electrode surface, wherein the planar distribution includes a number of rectangular sub-areas. In such application, each rectangular sub-area may define a chip. Hence, the master electrode may be provided with a topographical pattern being periodic and defining a plurality of adjacently arranged rectangular chips. The rectangular shape of each chip is usually necessary because of the need for facilitated dicing and chip separation later in the device manufacturing process.

During ECPR, current will flow radially through the master electrode to the seeded substrate and out via an external connection at the edge of the substrate. If the pattern density across the master electrode is exhibiting variations close to the edge of the circular carrier element, this may result in uneven plating thickness across the substrate being processed by ECPR due to non-uniform current flow. Thus, the chips having a position corresponding to the central part of the master electrode will be different from the chips having a position corresponding to the more peripheral part of the master electrode. Quality may therefore vary between different chips.

### SUMMARY OF THE INVENTION

Accordingly, the present invention seeks to mitigate, alleviate or eliminate one or more of the above-identified deficiencies and to provide an improved ECPR master electrode as well as a method for manufacturing such master electrode.

It is an object of the present invention to provide a circular ECPR master electrode to be used in rectangular chip fabrication.

It is a further object of the present invention to provide a method for manufacturing such master electrode using a simple lithographic process, which may be done by standard semiconductor process equipment.

It is a further object of the present invention to provide a method for manufacturing such master electrode while allowing for uniform quality of the manufactured chips.

It is an idea of the present invention to provide a circular ECPR master electrode having a topographical pattern defining electrochemical cells arranged in a periodic rectangular pattern, wherein the topographical pattern is truncated by means of a circular periphery.

The invention is defined in claims 1 and 15.

According to a first aspect of the invention, a method for providing an ECPR master electrode is provided. The method comprises the step of providing a circular carrier element having an electrically conducting electrode surface on a back side and a topographical pattern with an at least partly electrically insulating top on a front side of said carrier element, said topographical pattern comprising a plurality of electrochemical cells in said carrier element, each one of said electrochemical cells comprising a bottom and at least one side wall, said bottom having an electrically conducting surface being conductively connected to the electrically conducting electrode surface on the back side through the carrier element, wherein the step of providing said topographical pattern comprises: passivating a peripheral part of the front side of the carrier element for forming an isolation region, said isolation region surrounding a circular device area; providing an etch mask across said device area and said isolation region; and etching the carrier element such that said electrochemical cells are formed at the device area, and such that the passivation of the isolation region provides a further etch mask for preventing the formation of electrochemical cells at said isolation region.

According to a second aspect of the invention, an ECPR master electrode is provided. The ECPR master electrode comprises a circular carrier element having an electrically conducting electrode surface on a back side and a topographical pattern with an at least partly electrically insulating top on a front side of said carrier element, said topographical pattern comprising a plurality of electrochemical cells in said carrier element, each one of said electrochemical cells comprising a bottom and at least one side wall, said bottom having an electrically conducting surface being conductively connected to the electrically conducting electrode surface on the back side through the carrier element, wherein said topographical pattern is distributed across a circular device area comprising a plurality of rectangular chip areas, and being truncated by a passivated area surrounding said device area.

### BRIEF DESCRIPTION OF THE DRAWINGS

Hereinafter, the invention will be described with reference to the appended drawings, wherein:
Fig. 1 is a top view of an ECPR master electrode according to an embodiment;
Fig. 2 is a side view of a master electrode and a substrate during ECPR;
Fig. 3 is a side view of a master electrode showing the periphery of the truncated topographical pattern according to an embodiment;
Fig. 4a-e are side views showing the manufacturing process of a master electrode according to an embodiment;
Fig. 5a and 5b are side views of a master electrode showing an edge isolation interface according to an embodiment;
Fig. 6 is a side view of a master electrode showing the edge isolation interface according to a further embodiment;
Figs. 7a-f are side views showing the manufacturing process of a master electrode according to a further embodiment;
Fig. 8 is a side view of a master electrode showing the periphery of the truncated topographical pattern according to a yet further embodiment;
Figs. 9a and 9b are schematic cross-sectional views of a master electrode having defects;
Fig. 10 is a schematic cross-sectional view of a master electrode according to an embodiment of the present invention;
Fig. 11 is a schematic cross-sectional view of a master electrode according to a further embodiment;
Fig. 12a is a schematic cross-sectional view of a master electrode according to another embodiment; and
Fig. 12b is a schematic cross-sectional view of the master electrode shown in Fig. 5a including electrical circuit details.

### DESCRIPTION OF EMBODIMENTS

Below, several embodiments of the invention will be described with references to the drawings. These embodiments are described in illustrating purpose in order to enable a skilled person to carry out the invention and to disclose the best mode. However, such embodiments do not limit the invention, but other combinations of the different features are possible within the scope of the invention.

Some general remarks are given below with regard to the master electrode and methods of forming the master electrode. Several methods are described for forming a master electrode that can be used for producing one or multiple layers of structures of one or multiple materials including using the ECPR technology described below. The methods generally include: forming a master electrode from a carrier element which is conducting and/or semiconducting in at least some parts; forming a conducting electrode layer which functions as anode in ECPR plating and cathode in ECPR etching on a front side of the master electrode; and forming an insulating pattern layer that defines the cavities in which ECPR etching or plating can occur in the ECPR process on said front side, such that conducting electrode surface(s) is/are obtained in the bottom of the cavities; in a way that makes possible electrical contact from an external power supply to the back side of the master electrode for allowing electron transfer through the master electrode to the front side thereof to the conducing electrode surface(s), such that said surface(s) will constitute anode(s) in ECPR plating and cathode(s) in ECPR etching.

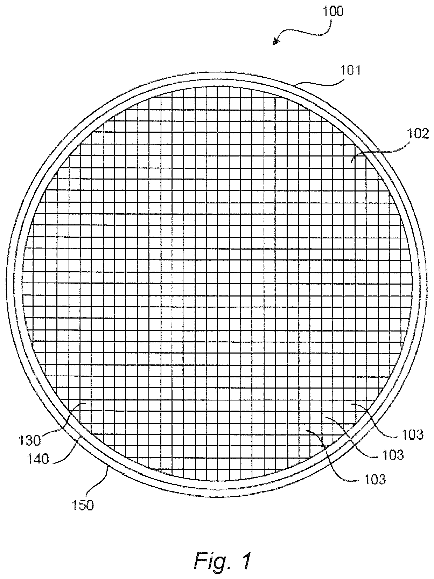

Now referring to Fig. 1, a top view of a master electrode 100 is shown. The master electrode 100 is formed by an at least partly electrically semiconducting circular carrier element 101. The carrier element may for example be a Si wafer. The size of the carrier element 101 may vary depending on the dimensions of the ECPR equipment to be used, but is typically of the size of standard semiconducting wafers, such as 100, 150, 200, 250, or 300 mm (4, 6, 8, 10, or 12 inches) in diameter. The upper surface 102, or front side of the master electrode 100 is divided into a plurality of rectangular segments 103, each segment 103 defining a device pattern, such as a chip layer, to be transferred to a substrate during an ECPR process.

The distribution of the rectangular segments 103 forms a device area 130. The device area 130 is terminated by a circular periphery. The circular periphery forms an interface to a surrounding passivated area 140. The passivated area 140 may have an annular shape. The passivated area 140 comprises an oxide isolation region. In this way, the topographical pattern of the device area 130 is truncated by the passivated area 140 for preventing plating at this region.

The passivated area 140 is surrounded by an edge region 150. The edge region 150 is recessed relative the device area 130 and the passivated area 140. The recessed part 119 of the carrier element 101 is formed in order to provide enough space for arranging an electrode (not shown) for providing electrical contact to the edge of the substrate to be plated during ECPR, without touching or damaging the master electrode. Furthermore, the surfaces of the recessed region 119 are passivated with an insulating material, such as silicon dioxide or silicon nitride, such that the electrodes connected to the substrate are not electrically connected to the master electrode.

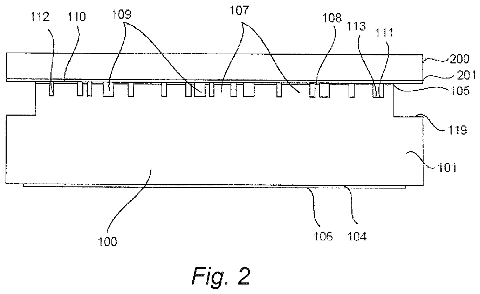

Now turning to Fig. 2, a side view of the master electrode 100 is schematically shown when arranged in close contact with a substrate 200 to be plated during ECPR. It should be noted that the master electrode and the substrate shown in this figure are not to scale, but shown only to illustrate different features in a suitable and illustrative way.

The carrier element 101 extends between a back side 104 and a front side 105, in such a way that electrical current is able to flow between the back side 104 and the front side 105. At the back side 104, an electrode layer 106 of an electrically conducting material is arranged. The electrode layer 106 may be formed by nickel silicide, or any other conducting material being suitable for a back side electrode layer during ECPR.

The front side 105 comprises a topographical pattern 107 with an at least partly electrically insulating top 108. The topographical pattern 107 is forming a plurality of electrochemical cells 109. That is, the planar surface extending between two adjacent electrochemical cells 109 is covered by an electrically insulating layer 110.

Each electrochemical cell comprises a bottom 111 and at least one side wall 112 extending from the bottom 111 to the electrically insulating top 108 such that a cavity is formed. The sidewalls of the cavity are covered by an electrically insulating layer which extends from the surface insulating layer 110 to the point at which the sidewall meets the bottom of the cavity 111. The bottom 111 has an electrically conducting surface 113 being conductively connected to the electrically conducting electrode surface 106 on the back side 104 by means of the carrier element 101. Thus, the carrier element 101 is disposed between the conducting electrode surface 106 and the electrically conducting surface 113. The conductive surface 113 is formed by any material being suitable as an anode/cathode in the ECPR.

The topographical pattern 107 extends from the center of the carrier element 101 radially towards the edge of the carrier element 101 and ends at a circular periphery arranged at a specific distance from the edge of the carrier element. The outer area 119 of the carrier element 101 not being occupied by the topographical pattern 107 includes the passivated area and a recessed region. The recessed region, arranged at the outer periphery of the carrier element 101 provides that the outer area of the master electrode is not in close contact with a substrate during ECPR. Preferably, the radial distance between the outer periphery of the topographical pattern 107 of the device area and the edge of the carrier element 101 is between 2.5 mm and 10 mm, and the width of the recessed part 119 of the carrier element is preferably 2 to 5 mm. The annular recess 119 may be formed using a resist mask and a deep silicon etch or by mechanical grinding or dicing of the carrier element 101.

Preferably the depth of the recess region 119 is between 100 and 200 microns deep. The recessed part 119 of the carrier element 101 is thus formed in order to provide enough space for arranging an electrode at the edge of the substrate to be plated during ECPR, without touching or damaging the master electrode.

The surfaces of the region outside the topographical pattern 107 of the device area, including the recessed portion 119 of the carrier element as well as the edge of the carrier element 101, may be passivated with an electrically insulating material. This prevents unwanted parasitic current flowing at the edges of carrier during the ECPR pattern transfer.

During ECPR, the master electrode 100 is put in close contact with a substrate 200 to be plated. The substrate 200 is provided with a seed layer 201 of electrically conductive material, such that conductive ions may be plated onto said seed layer 201.

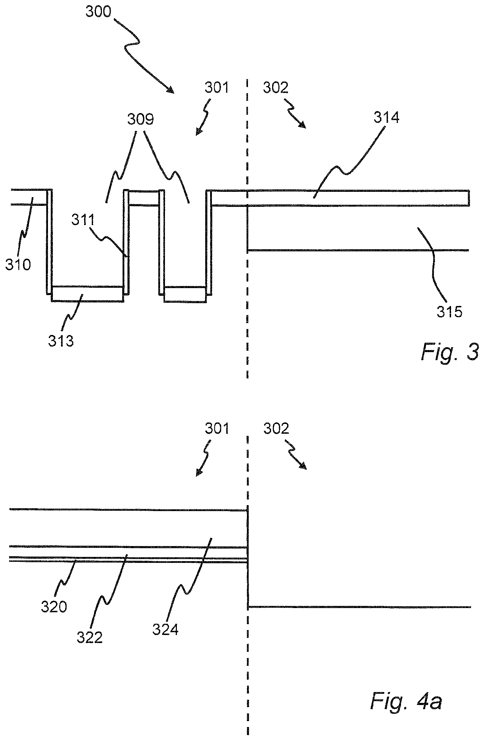

Now turning to Fig. 3, an enlarged view of the edge of the circular truncated pattern 107 of the device area 130 is shown. The details of Fig. 3 indicate the constructional configuration of a master electrode 300 being ready to use with an ECPR process. On the left side of Fig. 3, i.e. the device area indicated by the reference numeral 301, electrochemical cells 309 in the form of cavities are shown with insulating materials 310, 311 on the upper surfaces surrounding said cavities as well as on the sidewalls. Further, a conducting material 313 is provided at the bottom of each cavity. On the right side of Fig. 3, i.e. the passivated area indicated by the reference numeral 302, a region is provided without any electrochemical cells. The region 302 comprises a stack of insulating films made up of an insulating hardmask material 314, arranged on top of a layer 315 of thick thermal oxide. Hence, the layer 315 provides what from hereon will be denoted as the oxide isolation. The oxide isolation region 302 is used to define the circular edge to the region of electrochemical cells 301 used for ECPR transfer. In the example shown in Fig. 3 the electrochemical cells 309 of the device area 301 do not overlap the oxide isolation region 302 but happen to be positioned adjacent to it. However, the case where an electrochemical cell overlaps the oxide isolation region 302 will be described later.

Fig. 4a-e show the steps used according to one embodiment for providing the oxide isolation region 302. A layer 320 of silicon dioxide is provided on the upper surface of the carrier element. Thereafter a layer 322 of silicon nitride is deposited on top of the layer 320 as is shown in Fig. 4a. Then, however still with reference to Fig. 4a, a mask aligner mask is used to define a circular resist pattern 324. Using the resist mask 324, the dielectric stack of silicon oxide and nitride 320, 322 is etched. In a subsequent step the exposed silicon of the carrier element is recessed at the oxide isolation region 302. These etch steps can preferably be carried out sequentially in the same etch chamber or using separate optimized etch processes in different etch chambers.

In order to create the circular resist pattern 324 the photo resist, which initially is arranged to cover the complete upper surface of the carrier element by means of e.g. spin coating equipment, may be exposed with a mask aligner using a circular chrome pattern on the mask. Another method of achieving the circular pattern 324 in the photo resist is to use an optical or chemical edge bead removal process commonly found on spin coater type semiconductor equipment.

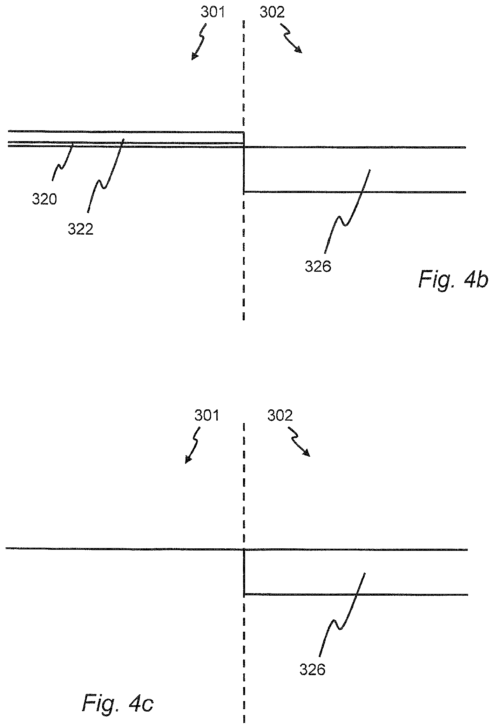

After etching the carrier element is exposed to a stripping and/or cleaning process such that the remaining photo resist is removed. The carrier element is thereafter subject to a wet or steam thermal oxidation process which grows a thick thermal oxide layer 326, as is shown in Fig. 4b. The preferred thickness of the isolation oxide is between 0.6 µm and 2.5 µm depending upon the selectivity to oxide of the silicon trench etch process used later to etch the cavities.

The layer of silicon nitride 322 provides a selective oxidation mask, such that the oxide layer 326 is grown only at the oxide isolation region 302.

As is show in Fig. 4c, the silicon nitride layer 322 as well as the silicon dioxide layer 320 can subsequently be stripped from the device area 301. In Fig. 4c it is shown that the level of the thermally grown oxide 326 is the same as that of the raw material of the carrier element. This is achieved by selecting the appropriate recess depth of the oxide isolation region 302 of the carrier element based on the thickness of the grown thermal oxide 326.

The removal of the oxide layers 320, 322 may preferably be followed by a cleaning step as well as a short step of thermal oxidation for growing a layer 328 of e.g. silicon dioxide on top of the carrier element.

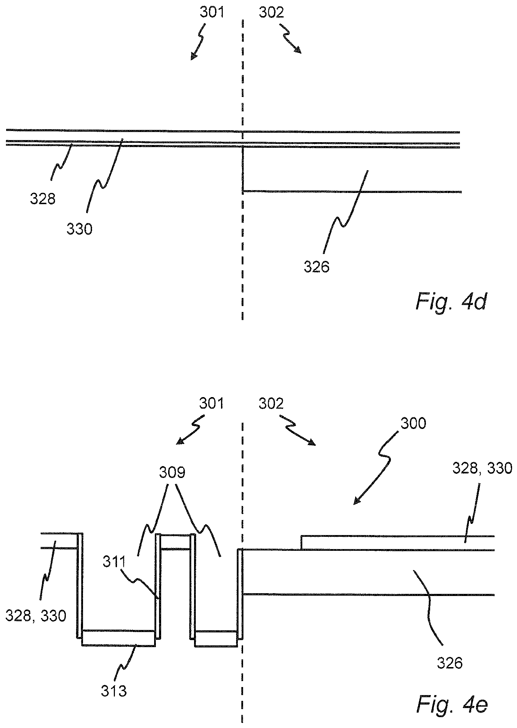

With reference to Fig. 4d, a further layer of dielectric 330 is deposited for forming a trench hardmask material.

In the subsequent steps a stepper or scanner may be used to pattern the upper surface of the carrier element, such that the lateral dimensions of the electrochemical cells are well defined in a photo resist layer (not shown) by exposure, development, and cleaning processes. The pattern of the photo resist is thereafter transferred to the dielectric hardmask layer 330. Since the stepper pattern overlaps the isolation region the topographical pattern, which is provided by etching the carrier element using the dielectric hardmask layer 330 as an etchmask, will be truncated by the oxide isolation region. As shown in Fig. 4e electrochemical cells 309 which overlap the isolation oxide region 302 are defined partly by the pattern of the stepper and partly by the circular edge of the isolation oxide region 302. In Fig. 4e, the layers 328, 330 correspond to the layer 310 as indicated in Fig. 3, while the oxide layer 326 corresponds to the oxide layer 315 as indicated in Fig. 3. The sidewall coverage 311 and the bottom layer 313 of conductive material are already described with reference to Fig. 3.

Further enhancements to the process will be discussed in the following. Electrochemical cells 309 may be located at the interface of the isolation oxide region 302. In this instance, the side wall of an electrochemical cell 109 may be located at the boundary between the device area 301 and the oxide region 302. In this situation a side wall of the electrochemical cell 309 may be defined at least partly by the circular edge of the isolation oxide region 302. Then the physical shape of the oxide layer 326 may be of importance. It is then important that the interface between the device area 301, and in this case the side wall of the electrochemical cell 309, and the edge of the oxide region 302 is vertical, such that the upper and outer edge, towards the oxide region 302 is as close to perpendicular as possible.

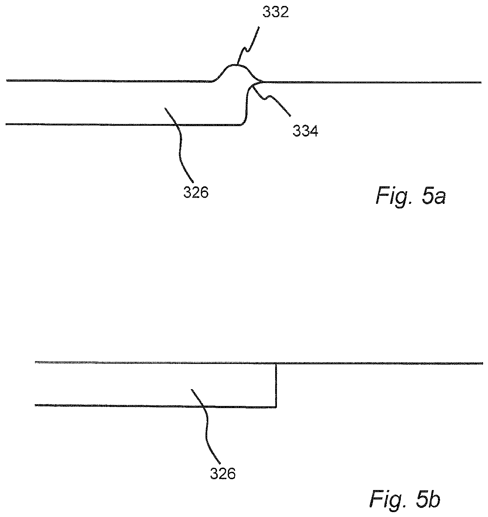

Referring to Figs. 5a and 5b, a detailed shape of the edge of the oxide isolation region 302 is shown. During formation of the oxide layer 326, the oxidation process typically creates a so called bird's head 332 and bird's beak 334. The bird's beak 334 is a result of oxygen diffusion along the thin oxide beneath the silicon nitride oxidation mask, while the bird's head 332 results from oxidation of the silicon corner region. During the deep silicon etch used to create the cavities some consumption of isolation oxide occurs, which can lead to a degradation in the silicon etch profile along the upper and outer edge of the electrochemical cell 309. This is then also a degradation of the silicon each profile at the interface between the device area 301 and the oxide region 302, resulting in a beveled upper and outer edge of the electrochemical cell 309. It is therefore desirable to create the isolation oxide edge as close as possible to an ideal shape, i.e. perpendicular, without the effects of the bird's beak and head. This is shown in Fig. 5b.

Suppression of the bird's beak 334 may to some degree be achieved by optimizing the ratio of silicon nitride to silicon dioxide. Elimination of the bird's beak 334 and bird's head 332 may however require further processing steps. One such process involves chemical/mechanical polishing to remove the elevation of the bird's head 332. The bird's head and beak can also be eliminated by using chemical/mechanical polishing in conjunction with a deposited oxide instead of the thermally grown oxide. In such schemes the oxide can be deposited using a number of deposition methods including but not limited to plasma enhanced oxide (PE-CVD), high density plasma (HDP) or low pressure chemical vapour deposition (LPCVD).

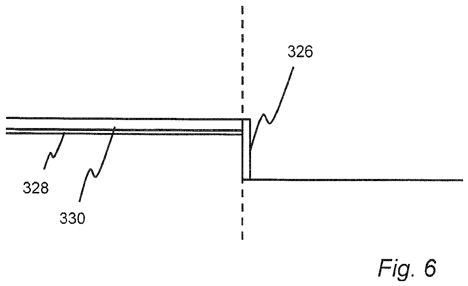

Another option is to use a sidewall masking step to prevent oxidation of the silicon sidewall. This is shown in figure 6, where a silicon nitride spacer 336 is formed on the sidewall after the silicon of the carrier element has been recessed but before the oxide layer 326 is grown.

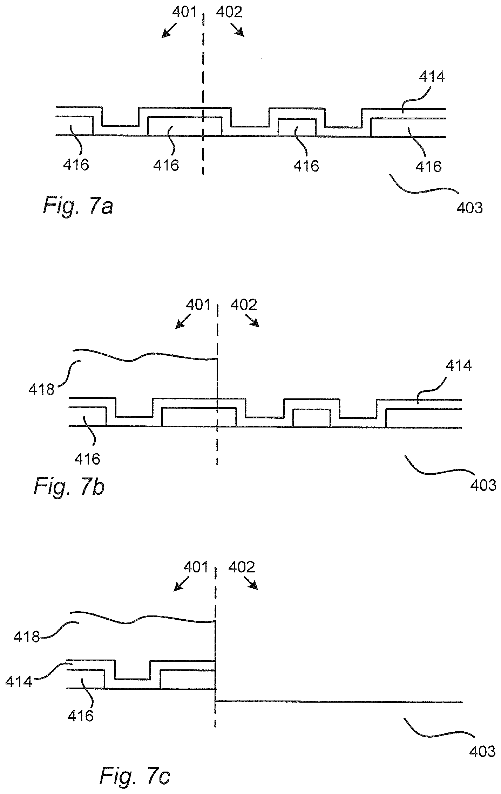

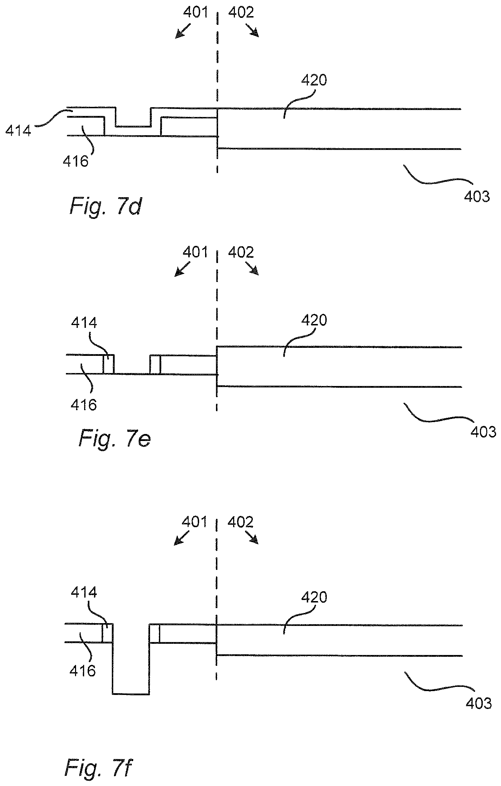

A further embodiment of the invention is described in Figs. 7a-f. In this embodiment etching of the cells outside of the device area 401 is blocked using a selectively grown thermal oxide. In this embodiment, a thin layer of silicon nitride 414 is deposited onto the hardmask material 416, after patterning of the hardmask material 416. The hardmask material 416 will later be used as an etch mask to form the cavities, and is preferably a dielectric hardmask material 416, such as silicon oxide, silicon nitride, etc. The etch mask is preferably provided by a lithographic process. Thereafter, RIE etching of the hard mask material 416 is performed. Subsequently, stripping of the resist is performed. When the etch mask is provided, the thin layer of silicon nitride 414 is deposited as shown in Fig. 7a. The region which will contain the active device region is shown as 401 and the circular region outside in which no ECPR will take place is shown as 402.

Referring to Fig. 7b, as a subsequent step, a second lithographic process is used for defining the circular periphery of the passivated area 402. This step is performed by coating a thick layer of resist 418 on the front side of the carrier element 403. Thereafter, the outer periphery of the master electrode is exposured and developed. The thickness of the resist 418 should preferably be sufficient to at least partially fill the depth of the topographical pattern of the etch mask.

In order to create a circular resist pattern the photoresist may be exposed with a mask aligner using a circular chrome pattern on the mask.

A further method of achieving the circular pattern in the thick photoresist may be to use an optical or chemical edge bead removal process, commonly found on spin coater type semiconductor equipment.

After the resist is patterned the silicon nitride 414 and hardmask material 416 is etched. The etching may be performed by using e.g. a RIE etch tool. The RIE etch removes the silicon nitride layer 414 and the hardmask material 416 as shown in Fig. 7c. In this step the raw material of the carrier element 403 may also be etched, such that any uneven topography of the carrier element 403 is minimized or reduced.

After etching and subsequent stripping of the photoresist the carrier element 403 of the master electrode may be subjected to a high temperature oxidation process as shown in Fig. 7d. The silicon nitride layer 414 will prevent oxidation of the central portion of the master electrode, i.e. the device area 401, while the outer portion of the master electrode, i.e. the passivated area 402, will be oxidized. At the same time, a recessed region of the master electrode and a bevel/edge of the carrier element will be oxidized. Consequently, the passivated area 402 is provided with an oxide layer 420.

In the following steps the cavities for forming the electrochemical cells of the topographic pattern are formed. The silicon nitride layer 414 of the device area 401 is first removed using e.g. an unmasked or blanket RIE process as depicted in Fig. 7e. The thermally grown oxide 420 on the surface of the master electrode of the passivated area 402 is etched only slightly during this etch process. This is due to the very large differential thicknesses and the chemistry used in the RIE process, which provides high SiN to SiO₂ selectivity. Following this step etching of the cavities is performed using deep silicon trench etching. The thick thermal oxide 420 will block the formation of the cavities in the passivated area 402.

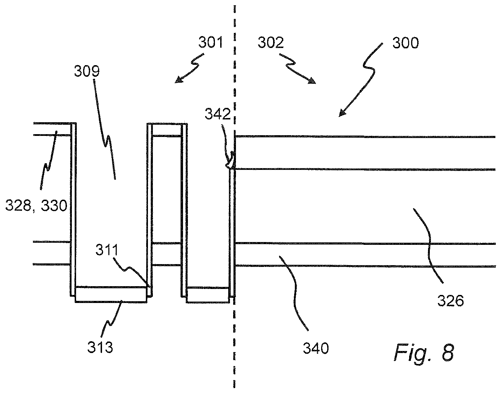

A further enhancement to the process is shown in Fig. 8. This enhancement involves the use of a carrier element substrate with a buried layer 340 to prevent parasitic leakage currents at the oxide isolation region 302. The parasitic leakage currents may result from an unwanted electrode layer on the periphery of the isolation oxide region, e.g. formed by the provision of a defect 342, or from roughness of the sidewall of the electrochemical cells created during the deep etch of the carrier element.

Buried layers of this kind are described in further details in the co-pending application PCT/EP2010/070645 by the same applicant, and may be represented in the carrier element by means of an epitaxial layer forming an increase of the resistance of said carrier element, a silicon-on-insulator structure, or a p-n or n-p junction, e.g. in the form of a bipolar transistor. Preferably, this kind of buried layer 340 is arranged in the upper part of the carrier element, between the front surface and the bottom of the electrochemical cells.

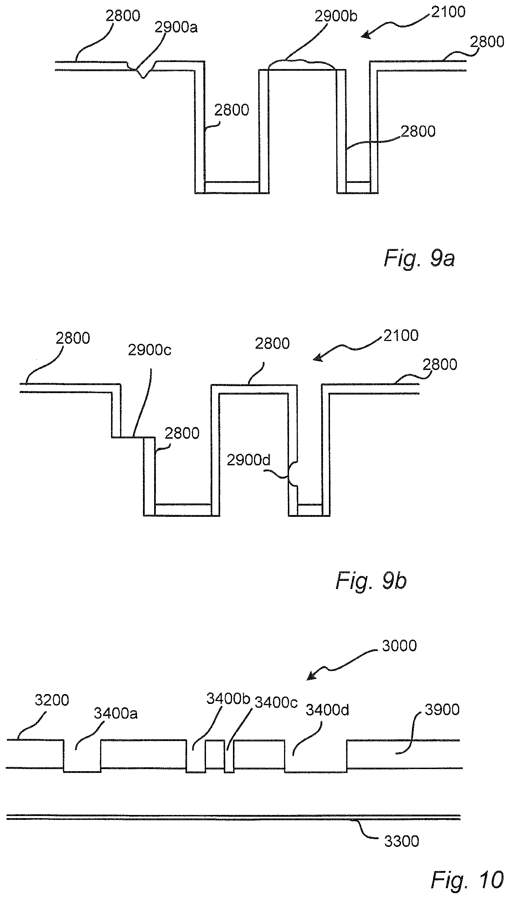

With reference to Fig. 9a, an example of a part of a master electrode 2100, according to one embodiment of the present invention, is shown. A layer of an electrically insulating material 2800 is arranged on the front side of the master electrode 2100, to be in physical contact with the substrate during ECPR, or at least in close adjacency of the substrate during ECPR. A plurality cavities are arranged on said front side, the side walls of said cavities also having the electrically insulating material arranged thereon, such that only the bottom of said cavities are intended to be electrically conductive and conductively connected to the backside of the master electrode 2100 during prefill or during ECPR. This embodiment is illustrated with defects present in the insulating material 2800. The insulating material 2800 is disruptive at two different positions 2900a and 2900b. At 2900a, a scratch or similar has caused the insulating material 2800, as well as the upper surface of the underlying substrate to be damaged and deformed. Due to the lack of insulating material at 2900a and 2900b, these areas may be unintentionally filled up with conducting electrode layer during the master manufacturing, which would normally only be deposited in the bottom of the masters cavities.

Before any plating may be performed during the ECPR process, the electrochemical cells of the master electrode are pre-filled with a bulk of conductive material, such as copper. This process, generally known as a pre-fill process, is performed by an electrochemical plating of a transfer conductive material at the bottom of each one of the electrochemical cells. When positioned in a plating chamber, the master electrode is connected to a voltage source allowing ions to be plated at the bottom of the electrochemical cells through an electrolyte in the electrochemical cells. Thus a bulk material at each bottom will be formed. Hence, when the master electrode 2100 is positioned within a plating chamber, electrolytic solution is allowed to fill the space at 2900a thus leading to a possible risk of unwanted plating current of the master at a position facing the defect 2900a. The material deposited (either electrode layer material, pre-filled material or both) at 2900a would create a short circuit between the master and a substrate, when they are placed in close contact with each other in the subsequent ECPR process, and an unwanted parasitic current would then pass which could significantly reduce the transfer rate of the ECPR process in the neighboring electrochemical cells - leading to very non-uniform thickness of the transferred material, unless the master electrode comprised features according to embodiments disclosed below.

At 2900b, a blocked etch type defect has formed during the trench etching process, and there is consequently no insulating material 2800 covering the area between the two adjacent electrochemical cells. During the ECPR process, parasitic currents would thus be able to flow from the master electrode to the substrate via the defect at 2900b, unless the master electrode comprised features according to embodiments disclosed below.

Defects can also be present on the sidewalls, as disclosed in Fig. 9b. In Fig. 9b sidewall defects 2900c and 2900d are disclosed. Sidewall defect 2900c may be obtained if a partial blocked etch defect is present leading to a 'stepped' profile on the sidewall of the cavity. Later application of the layer of insulating material 2800 may then risk to only cover vertical surfaces, depending on application method. Thus, a plateau is formed which may be of a conducting or semiconducting material, depending on which carrier is used. During the ECPR process, parasitic currents would thus be able to flow from the master electrode to the substrate via the defect at 2900b, unless the master electrode comprised features according to embodiments disclosed below. In the sidewall defect 2900d, the application of the layer of electrically insulating material has failed, and a hole or crater has been formed, through which the same kind of parasitic currents would be able to flow, in accordance with above.

Turning to Fig. 10, a master electrode 3000 according to an embodiment is shown. The master electrode 3000 is formed by a carrier element 3100 having a back side being provided with an electrode surface 3300. The electrode surface 3300 may be an electrode layer. The master electrode 3000 further comprises a front side 3200. The carrier element 3100 comprises a conductive and/or semi conductive material, such that electrical current may flow from the electrode surface 3300 to the front side 3200 and into a substrate (not shown) arranged in close contact with the front side of the master electrode 3000, through an electrolyte between the master electrode 3000 and the substrate, and also electrical current in the opposite direction. The carrier element 3100 may be a disc shape element (such as a wafer) of said conductive or semi conductive material. The front side 3200 comprises a plurality of electroplating cells 3400a, 3400b, 3400c, etc. The electroplating cells 3400a, 3400b, 3400c, etc. are formed as a topographical pattern on the front side 3200. The bottoms of the electroplating cells 3400a - 3400d comprise an electrode surface. The electrode surface may be formed on an electrode layer, applied in the bottom of the electroplating cells 3400a - 3400d. The electrode surfaces in the bottom of the electroplating cells 3400a - 3400d are conductively connected to the electrode surface 3300 on the back side of the master electrode 3000. The top surface of the front side 3200, i.e. the top surface of the topographical pattern, is electrically insulating by means of the provision of an electrically insulating layer. In the same way, the sidewalls of the electroplating cells 3400a-3400d are also provided with an electrically insulating layer arranged thereon, such that only the bottom of said cavities are intended to be electrically conductive and conductively connected to the backside of the master electrode 3000 during prefill or during ECPR. The electrolyte will then be arranged in the electroplating cells 3400a, 3400b, 3400c, etc. The carrier element may e.g. be formed by a 6, 8, or 12 inch Si wafer, depending on the size of the substrates to be plated by the ECPR process. Other semiconducting materials may also be chosen as the basic material structure of the master electrode 3000, like for example III-V materials commonly used within the semiconductor industry.

The carrier element 3100 of the master electrode 3000 comprises a structure 3900 which is arranged to obstruct or prevent current during a voltage between the electrode surface 3300 and the front side 3200 of the master electrode 3000, and vice versa. The structure 3900 may thus be a current suppression or current blocking structure. The structure 3900 may also be a separate structure, such as layer, arranged on top of the carrier element 3100, when the front side of the master electrode 3000 is facing upwards. In this respect, the structure 3900 is arranged to form resistance, such as a high series resistance, between the electrode layer 3300, when the back side of the master electrode 3000 is provided with a separate electrode layer 3300, and the front side 3200, i.e. the top surface of the master electrode 3000 being in contact with a seed layer of the substrate during plating by the ECPR process. When the carrier element 3100 is doped at a relatively high rate, for example p+, it is considered as a fairly good conductor. The structure 3900 may comprise a layer in an upper zone of the carrier element 3100 or on top of the carrier element 3100 of the master electrode reducing the conductivity of the master electrode 3000. In Fig. 10, the structure 3900 is formed as a layer having a much lower doping level, thus forming the increased resistance of the master electrode 3000. The structure 3900 in Fig. 10 may then be a Si layer having lower, such as substantially lower, conductivity than the carrier element 3100 beneath the structure 3900. The structure 3900 may be formed either as an intrinsic epitaxial layer, or as lightly doped epitaxial layer. The intrinsic epitaxial layer may be undoped. In the case of a silicon substrate, the carrier element 3100 may have a doping level in the range 10¹⁷ to 10¹⁹ atoms/cm3. To achieve the immunity to defects, the doping level of the structure 3900 may then be in the range of 10¹³ to 10¹⁷ atoms/cm3. When the carrier element 3100 is comprising a p-type semiconductor typical doping atoms used include boron, indium and gallium whilst in the case of an n-type doped carrier element typical doping atoms could include arsenic, phosphorus and antimony. Typical dopants used in the epitaxial layer include boron, arsenic and phosphorus.

The thickness of the structure 3900, which structure extends from the uppermost part of the carrier element 3100 or on top of the carrier element 3100, in between the insulating surface on the front side of the master electrode 3000 and downwards towards the electrode surface in the bottom of the electrochemical cells, is preferably less than the depth of the electrochemical cells 3400a - 3400d formed at the front side 3200 of the master electrode 3000. In this way the structure 3900 will extend between the electrochemical cells 3400a - 3400d, such that the increased resistance is obtained above the bottom of the electrochemical cells 3400a - 3400d when the front side 3200 thereof is facing upwards. This is advantageous in that the structure 3900 does not affect the conducting properties of the parts of the master electrode 3000 being provided at the bottom of the electrochemical cells. That is, during manufacturing of the master electrode 3000 the deep trench etch is preferably provided completely through the structure 3900.

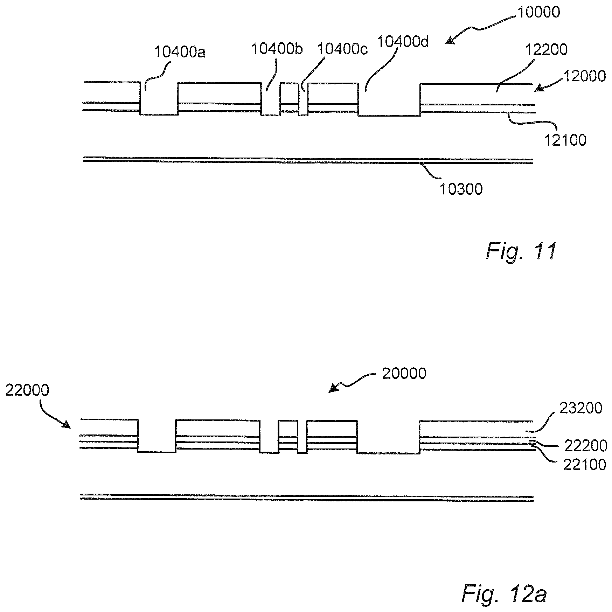

The structure 3900 may also comprise a layer in an upper zone of the carrier element 3100 or on top of the carrier element 3100 of the master electrode which is the opposite doping type to the carrier element. The structure 3900 in Fig. 10 may then be a Si layer which is doped n-type in the case of a p+ carrier element. The layer 3900 may also be p-type in the case of a n+ doped carrier element. To achieve the immunity to defects, the doping level of the structure 3900 may then be in the range of 10¹³ to 10¹⁷ atoms/cm³. When the carrier element 3100 is comprising a p-type semiconductor typical doping atoms used include boron, indium and gallium whilst in the case of an n-type doped carrier element typical doping atoms could include arsenic, phosphorus and antimony. Typical dopants used in the epitaxial layer include boron, arsenic and phosphorus. The use of ion implantation and furnace annealing also provide an alternative method of forming the desired structure. In this case typical dopants used include boron, arsenic and phosphorus. With reference to Fig. 11, another embodiment of a master electrode 10000 will be described. The master electrode 10000 is formed by a carrier element 10100 having a back side having being provided with an electrode surface 10300, such as an electrode layer, and a front side 10200 comprising a plurality of electroplating cells 10400a, 10400b, 10400c, etc, formed as a topographical pattern on the front side 10200, with electrode surfaces in the bottoms thereof. The top surface of the topographical pattern is electrically insulating.

The carrier element 10100 of the master electrode 10000 comprises a structure 12000 which is arranged to obstruct or prevent electrical current from passing from the electrode surface 10300 of the back side to the front side 10200 of the master electrode, in accordance with the structure 3900 in the embodiment according to Fig. 10. The structure 12000 is thus arranged to form resistance, such as a high series resistance, between the electrode layer 10300 on the back side and the front side 10200 of the carrier element 10100, i.e. the electrically insulating top surface of the master electrode 10000 being in contact with a seed layer of the copy substrate during plating. When the Si substrate is doped at a relatively high rate, for example p+, it is considered as a fairly good conductor. The structure 12000 comprises a silicon-on-insulator at the most upper part of the carrier element 10100 of the master electrode, reducing the conductivity of the master electrode 10000. In Fig. 11, the structure 12000 is formed as an insulating layer 12100, e.g. SiO₂. The insulating layer 12100 may be combined with an epitaxial layer 12200 of low doped Si grown on top of the insulating layer 12100.

The thickness of the structure 12000, which structure extends from the uppermost part of the Si carrier element 10100 of the master electrode 10000 and downwards towards the electrode layer 10300, is preferably less than the depth of the electrochemical cells 10400a - 10400d formed at the front side 10200 of the master electrode 10000. The advantages of the master electrode 10000 described with reference to Fig. 10 apply also for the embodiment shown in Fig. 11.

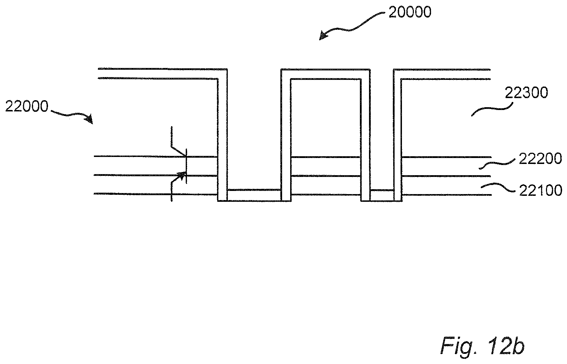

A yet further embodiment of a master electrode is shown in Fig. 12a and 12b. Here, the master electrode 20000 has a similar construction as the master electrodes shown in Fig. 10 and Fig. 11. In this embodiment, the structure 22000 is formed such that a vertical bipolar junction transistor is present in the upper part of the carrier element 20000. The structure 22000 is having either a p-n-p or n-p-n junction arrangement. In the case of the p-n-p arrangement, the Si carrier element 20100 is typically p+ doped with a grown epitaxial layer 22100 of p- doped material. On said p-material, a further layer 22200 of an n+ doped material is grown, and finally a layer 22300 of p- doped material is grown on top of the intermediate n+ layer 22200. The layers 22100, 22200 and 22300 can be formed using a variety of processes including but not limited to CVD epitaxial deposition with alternating dopant sources and ion implantation in conjunction with epitaxial layer deposition.

Thicknesses of the buried layer can be adjusted according to the depth of the cavities in the master being less than a micron to several microns. The doping profile of the buried layer depends upon the process used to create the layers 22100, 22200, 22300. Typical layer thicknesses may be from 1 to several microns.

The thickness of the structure 22000, which structure extends from the uppermost part of the Si carrier element 20100 of the master electrode 20000 and downwards towards the electrode layer 20300, is also in this case preferably less than the depth of the electrochemical cells formed at the front side of the master electrode 20000. This is advantageous in that the structure 22000 does not affect the conducting properties of the parts of the carrier element 20100 being provided with the electrochemical cells. That is, during manufacturing of the master electrode 20000 the deep trench etch of the carrier element 20100 is provided completely through the structure 22000.

The front side of the master electrode 20000 is shown in further details in Fig. 12b. The doping type of the layer 22200 is opposite polarity to the surrounding layers 22100 and 22300 such that a vertical junction transistor is formed with the layer 22200 and base of the transistor. The emitter and collector regions of the transistor are reversible depending upon the mode of operation. Back to back diodes are created in this structure 22000 at the junction of the materials 22100 to 22200 and 22300 to 22200. Junction diodes when reverse biased by an external voltage source are highly effective at blocking current flow. Before any plating may be performed, the electrochemical cells of the master electrode 20000 are pre-filled with a bulk of conductive material, such as copper. This process, generally known as a pre-fill process, is performed by an electrochemical plating of a transfer conductive material at the bottom of each one of the electrochemical cells. When positioned in a plating chamber, the master electrode is connected to a voltage source allowing ions to be plated at the bottom of the electrochemical cells through an electrolyte in the electrochemical cells. Thus a bulk material at each bottom will be formed. This means that the bottom p-n junction, i.e. the junction formed between the p- layer 22100 and the n+ layer 22200 is reverse biased and hence current is prevented to flow through the bottom p-n junction.

After the pre-fill process, the master electrode 20000 is used for transferring the bulk material grown at the bottom of each electrochemical cell to a seed layer of a substrate arranged in close contact with the front side of the master electrode 20000 during an ECPR process. In this process, the master electrode is again connected to a voltage source for allowing ions to flow from the bulk material of the electrochemical cells to the substrate to be plated. In this mode, the upper p-n junction, i.e. the junction formed between the n+ layer 22200 and the upper p- layer 22300 will be reversed biased and hence current is prevented to flow through the upper p-n junction.

The structure 22000 will block parasitic currents as long as the voltage being applied to the master electrode 20000 is much less than the BVCEO (breakdown voltage collector-to-emitter with base open) of the p-n-p or n-p-n transistor. It is thus preferred to provide the base layer with a relative high doping level in order to suppress upward gain and to avoid punch-through caused by the upper and lower depletion regions meeting in the layer 22200.

For a master electrode according to any of the previously described embodiments, the depth of each electrochemical cell may be in the range of 1 to 100 microns, such as between 2 and 20 microns. The lateral dimensions of each cell is being dependent on the pattern to be replicated, but may range from sub-micron and upwards.

In a typical example, the depth of an electrochemical is 15 microns. Consequently, the thickness of the structure for preventing the parasitic currents due to defects on the master electrode is less than 15 micrometers.

In all the embodiments disclosed in Figs. 9 to 12, and the corresponding passages above, the sidewalls of the electroplating cells and the top surface intended to face the substrate to plated/etched in ECPR, are also provided with an electrically insulating layer arranged thereon, such that only the bottom of said cavities are intended to be electrically conductive and conductively connected to the backside of the master electrode 2100, 3000, 10000, 20000 during prefill or during ECPR.

It is readily understood that all references to lower/upper are merely for illustrative purposes, without any limiting effect on the scope of protection. Also, it should be noted that the dimensions of the different features and layers shown in the figures are not to scale, but should be interpreted only for illustrative purpose. All references in this application to actual values, such as layer thicknesses etc, should also only be read as examples of suitable dimensions.

In the claims, the term "comprises/comprising" does not exclude the presence of other elements or steps. Additionally, although individual features may be included in different claims, these may possibly advantageously be combined, and the inclusion in different claims does not imply that a combination of features is not feasible and/or advantageous. In addition, singular references do not exclude a plurality. The terms "a", "an", "first", "second" etc do not preclude a plurality. Reference signs in the claims are provided merely as a clarifying example and shall not be construed as limiting the scope of the claims in any way.

## Claims

1. A method for providing an ECPR master electrode, comprising the step of:
providing a circular carrier element (101) having an electrically conducting electrode surface (106) on a back side (104) and a topographical pattern (107) defining a plurality of electrochemical cells (109) in the carrier element on a front side thereof (105), each electrochemical cell comprising a side wall (112) and a bottom (111), wherein the planar surface extending between two adjacent electrochemical cells (109) is covered by an electrically insulating layer (110) and wherein the bottom (111) has an electrically conductive surface (113) being conductively connected to the electrically conducting electrode surface (106) on the back side through the carrier element,
wherein the step of providing said topographical pattern comprises:
- passivating a peripheral part of the front side of the carrier element for forming an isolation region, said isolation region (140) surrounding a circular device area;
- providing a patterned dielectric hardmask layer (330) across said device area and said isolation region; and
- etching the carrier element such that said electrochemical cells are formed at the device area, wherein the passivation of the isolation region further prevents the formation of electrochemical cells by etching at said isolation region.

2. The method according to claim 1, wherein providing a patterned dielectric hardmask layer across said device area and said isolation region comprises providing a plurality of rectangular chip areas, each chip area forming a portion of said hardmask layer.

3. The method according to claim 1 or 2, wherein providing a patterned dielectric hardmask layer across said device area and said isolation region comprises covering the complete front side of said carrier element with said hardmask layer.

4. The method according to any one of claims 1 to 3, wherein the step of passivating a peripheral part of said front side of the carrier element comprises:
- providing an etch mask on top of said device area;
- etching the front side of the carrier element for forming a recessed isolation region;
- providing a selective oxidation mask on top of said device area;
- growing an oxide on said front side of said carrier element; and
- removing said selective oxidation mask from said device area.

5. The method according to claim 4, wherein said etch mask is identical with said selective oxidation mask.

6. The method according to claim 4 or 5, further comprising the step of passivating at least one sidewall on the etched portion of the recessed isolation region.

7. The method according to any one of claims 4 to 6, wherein providing the etch mask comprises
- providing a first layer of silicon nitride (322) on top of said device area;
- providing a resist layer on top of said layer of silicon nitride;
- removing a peripheral part of said resist layer; and
- etching through the first layer of silicon nitride using the remaining resist layer as an etch mask.

8. The method according to claim 7, wherein the step of etching through the first layer of silicon nitride is performed by an anisotropic process.

9. The method according to any one of claims 1 to 8, further comprising the step of providing an annular recess at said peripheral part.

10. The method according to any one of claims 1 to 9, further comprising the step of polishing said front side of said carrier element after the step of passivating the peripheral part but before the step of providing an etch mask.

11. The method according to any one of claims 1 to 10, further comprising the step of providing an electrical current preventing or obstructing structure between said front side and said back side of said carrier element.

12. The method according to claim 11, wherein the step of providing an electrical current preventing or obstructing structure between said front side and said back side of said carrier element comprises providing an epitaxial layer as a buried layer (340) of said carrier element.

13. The method according to claim 11, wherein the step of providing an electrical current preventing or obstructing structure between said front side and said back side of said carrier element comprises providing a bipolar transistor as a buried layer of said carrier element.

14. The method according to claim 11, wherein the step of providing an electrical current preventing or obstructing structure between said front side and said back side of said carrier element comprises building a silicon-on-insulator structure as a buried layer of said carrier element.

15. An ECPR master electrode (100, 300), comprising a circular carrier element (101) having an electrically conducting electrode surface (106) on a back side (104) and a topographical pattern (107, 307) defining a plurality of electrochemical cells (109) in the carrier element on a front side thereof (105), each electrochemical cell comprising a side wall (112) and a bottom (111), wherein the planar surface extending between two adjacent electrochemical cells (109) is covered by an electrically insulating layer (110) and wherein the bottom (111) has an electrically conductive surface (113) being conductively connected to the electrically conducting electrode surface (106) on the back side (104) through the carrier element (101), wherein
said topographical pattern (107, 307) is distributed across a circular device area (130, 301) comprising a plurality of rectangular chip areas (103), and being truncated by a passivated area (140, 302) surrounding said device area (130, 301).

16. The ECPR master electrode according to claim 15, wherein said passivated area (140, 302) comprises an oxide layer (315, 326).

17. The ECPR master electrode according to claim 15 or 16, wherein the carrier element (101) comprises an annular recess outside the passivated area (140, 302).

18. The ECPR master electrode according to claim 17, wherein said annular recess extends from the outer circular periphery of the passivated area (140, 302) to the edge of the carrier element (101).

19. The ECPR master electrode according to any one of claims 15 to 18, further comprising an electrical current preventing or obstructing structure (3900, 12000, 22000) between said front side (3200) and said back side.

20. The master electrode according to claim 19, wherein said carrier element is conducting or semiconducting, wherein said structure (3900, 12000, 22000) is arranged as a buried layer of said carrier element.

21. The master electrode according to claim 19 or 20, wherein at least one electrochemical cell of said plurality of electrochemical cells (3400a-d, 10400a-d extends through said structure (3900, 12000, 22000).

22. The master electrode according to any one of claims 19 to 21, wherein said structure (3900) comprises an epitaxial layer forming an increase of the resistance of said carrier element.

23. The master electrode according to claim 22, wherein said structure (3900) is an intrinsic epitaxial layer.

24. The master electrode according to claim 22, wherein said structure (3900) is a pepitaxial layer.

25. The master electrode according to claim 24, wherein the p-epitaxial layer has a doping level in the range 10¹³ to 10¹⁷ atoms/cm3.

26. The master electrode according to any one of claims 19 to 23, wherein said structure (3900) is a p-n junction.

27. The master electrode according to any one of claims 19 to 23, wherein said structure (3900) is an n-p junction.

28. The master electrode according to any one of claims 19 to 22, wherein said structure (22000) comprises a bipolar transistor, comprising at least one p-n junction.

29. The master electrode according to any one of claims 19 to 22, wherein said structure (22000) comprises a bipolar transistor, comprising at least one n-p junction.

30. The master electrode according to claim 29, wherein said bipolar transistor is a p-n-p transistor or n-p-n transistor.

31. The master electrode according to any one of claims 19 to 22, wherein said structure (12000) comprises an insulating layer (12100).

## Patentansprüche

1. Verfahren zur Bereitstellung einer ECPR-Masterelektrode, umfassend den Schritt des:
Bereitstellens eines kreisförmigen Trägerelements (101), das eine elektrisch leitende Elektrodenoberfläche (106) an einer Rückseite (104) und ein topographisches Muster (107), welches eine Vielzahl elektrochemischer Zellen (109) in dem Trägerelement an einer Vorderseite (105) davon definiert, aufweist, wobei jede elektrochemische Zelle eine Seitenwand (112) und einen Boden (111) umfasst, wobei die sich zwischen zwei benachbarten elektrochemischen Zellen (109) erstreckende planare Oberfläche mit einer elektrisch isolierenden Schicht (110) bedeckt ist und wobei der Boden (111) eine elektrisch leitende Oberfläche (113) aufweist, die mit der elektrisch leitenden Elektrodenoberfläche (106) an der Rückseite durch das Trägerelement hindurch leitfähig verbunden ist,
wobei der Schritt des Bereitstellens des topographischen Musters umfasst:
- Passivieren eines peripheren Teils der Vorderseite des Trägerelements zur Bildung eines Isolationsbereichs, wobei der Isolationsbereich (140) einen kreisförmigen Vorrichtungsbereich umgibt;
- Anbringen einer mit einem Muster versehenen dielektrischen Hartmaskenschicht (330) über dem Vorrichtungsbereich und dem Isolationsbereich; und
- Ätzen des Trägerelements derart, dass besagte elektrochemische Zellen an dem Vorrichtungsbereich gebildet werden, wobei die Passivierung des Isolationsbereichs weiter die Bildung elektrochemischer Zellen durch Ätzen an diesem Isolationsbereich verhindert.

2. Verfahren nach Anspruch 1, wobei das Anbringen einer mit einem Muster versehenen dielektrischen Hartmaskenschicht über dem Vorrichtungsbereich und dem Isolationsbereich das Bereitstellen einer Vielzahl rechteckiger Chipbereiche umfasst, wobei jeder Chipbereich einen Teil der Hartmaskenschicht bildet.

3. Verfahren nach Anspruch 1 oder 2, wobei das Anbringen einer mit einem Muster versehenen dielektrischen Hartmaskenschicht über dem Vorrichtungsbereich und dem Isolationsbereich das Bedecken der gesamten Vorderseite des Trägerelements mit der Hartmaskenschicht umfasst.

4. Verfahren nach einem der Ansprüche 1 bis 3, wobei der Schritt des Passivierens eines peripheren Teils der Vorderseite des Trägerelements umfasst:
- Anbringen einer Ätzmaske oben auf dem Vorrichtungsbereich;
- Ätzen der Vorderseite des Trägerelements zur Bildung eines vertieften Isolationsbereichs;
- Anbringen einer selektiven Oxidationsmaske oben auf dem Vorrichtungsbereich;
- Züchten eines Oxids an der Vorderseite des Trägerelements; und
- Entfernen der selektiven Oxidationsmaske von dem Vorrichtungsbereich.

5. Verfahren nach Anspruch 4, wobei die Ätzmaske mit der selektiven Oxidationsmaske identisch ist.

6. Verfahren nach Anspruch 4 oder 5, weiter den Schritt des Passivierens mindestens einer Seitenwand an dem geätzten Teil des vertieften Isolationsbereichs umfassend.

7. Verfahren nach einem der Ansprüche 4 bis 6, wobei das Bereitstellen der Ätzmaske umfasst
- Anbringen einer ersten Schicht aus Siliziumnitrid (322) oben auf dem Vorrichtungsbereich;
- Anbringen einer Resistschicht oben auf der Schicht aus Siliziumnitrid;
- Entfernen eines peripheren Teils der Resistschicht; und
- Ätzen durch die erste Schicht aus Siliziumnitrid hindurch unter Nutzung der verbleibenden Resistschicht als Ätzmaske.

8. Verfahren nach Anspruch 7, wobei der Schritt des Ätzens durch die erste Schicht aus Siliziumnitrid hindurch durch einen anisotropen Prozess durchgeführt wird.

9. Verfahren nach einem der Ansprüche 1 bis 8, weiter den Schritt des Anbringens einer ringförmigen Ausnehmung an dem peripheren Teil umfassend.

10. Verfahren nach einem der Ansprüche 1 bis 9, weiter den Schritt des Polierens der Vorderseite des Trägerelements nach dem Schritt des Passivierens des peripheren Teils, jedoch vor dem Schritt des Anbringens einer Ätzmaske umfassend.

11. Verfahren nach einem der Ansprüche 1 bis 10, weiter den Schritt des Bereitstellens einer elektrischen Strom verhindernden oder hemmenden Struktur zwischen der Vorderseite und der Rückseite des Trägerelements umfassend.

12. Verfahren nach Anspruch 11, wobei der Schritt des Bereitstellens einer elektrischen Strom verhindernden oder hemmenden Struktur zwischen der Vorderseite und der Rückseite des Trägerelements das Bereitstellen einer Epitaxialschicht als eingebettete Schicht (340) des Trägerelements umfasst.

13. Verfahren nach Anspruch 11, wobei der Schritt des Bereitstellens einer elektrischen Strom verhindernden oder hemmenden Struktur zwischen der Vorderseite und der Rückseite des Trägerelements das Bereitstellen eines bipolaren Transistors als eingebettete Schicht des Trägerelements umfasst.

14. Verfahren nach Anspruch 11, wobei der Schritt des Bereitstellens einer elektrischen Strom verhindernden oder hemmenden Struktur zwischen der Vorderseite und der Rückseite des Trägerelements das Aufbauen einer Siliziumauf-Isolator-Struktur als eingebettete Schicht des Trägerelements umfasst.

15. ECPR-Masterelektrode (100, 300), umfassend
ein kreisförmiges Trägerelement (101), das eine elektrisch leitende Elektrodenoberfläche (106) an einer Rückseite (104) und ein topographisches Muster (107, 307), welches eine Vielzahl elektrochemischer Zellen (109) in dem Trägerelement an einer Vorderseite (105) davon definiert, aufweist, wobei jede elektrochemische Zelle eine Seitenwand (112) und einen Boden (111) umfasst, wobei die sich zwischen zwei benachbarten elektrochemischen Zellen (109) erstreckende planare Oberfläche mit einer elektrisch isolierenden Schicht (110) bedeckt ist und wobei der Boden (111) eine elektrisch leitende Oberfläche (113) aufweist, die mit der elektrisch leitenden Elektrodenoberfläche (106) an der Rückseite (104) durch das Trägerelement (101) hindurch leitfähig verbunden ist, wobei
das topographische Muster (107, 307) über einen kreisförmigen Vorrichtungsbereich (130, 301) verteilt ist, der eine Vielzahl rechteckiger Chipbereiche (103) umfasst, und durch einen passivierten Bereich (140, 302), der den Vorrichtungsbereich (130, 301) umgibt, abgeschnitten ist.

16. ECPR-Masterelektrode nach Anspruch 15, wobei der passivierte Bereich (140, 302) eine Oxidschicht (315, 326) umfasst.

17. ECPR-Masterelektrode nach Anspruch 15 oder 16, wobei das Trägerelement (101) außerhalb des passivierten Bereichs (140, 302) eine ringförmige Ausnehmung umfasst.

18. ECPR-Masterelektrode nach Anspruch 17, wobei die ringförmige Ausnehmung sich von dem äußeren kreisförmigen Umfang des passivierten Bereichs (140, 302) bis zum Rand des Trägerelements (101) erstreckt.

19. ECPR-Masterelektrode nach einem der Ansprüche 15 bis 18, weiter eine elektrischen Strom verhindernde oder hemmende Struktur (3900, 12000, 22000) zwischen der Vorderseite (3200) und der Rückseite umfassend.

20. Masterelektrode nach Anspruch 19, wobei das Trägerelement leitend oder halbleitend ist, wobei die Struktur (3900, 12000,22000) als eingebettete Schicht des Trägerelements angeordnet ist.

21. Masterelektrode nach Anspruch 19 oder 20, wobei mindestens eine elektrochemische Zelle der Vielzahl elektrochemischer Zellen (3400a-d, 10400a-d) sich durch die Struktur (3900, 12000, 22000) erstreckt.

22. Masterelektrode nach einem der Ansprüche 19 bis 21, wobei die Struktur (3900) eine Epitaxialschicht umfasst, die einen Anstieg des Widerstands des Trägerelements bildet.

23. Masterelektrode nach Anspruch 22, wobei die Struktur (3900) eine intrinsische Epitaxialschicht ist.

24. Masterelektrode nach Anspruch 22, wobei die Struktur (3900) eine p-Epitaxialschicht ist.

25. Masterelektrode nach Anspruch 24, wobei die p-Epitaxialschicht einen Dotierungsgrad im Bereich von 10¹³ bis 10¹⁷ Atome/cm³ aufweist.

26. Masterelektrode nach einem der Ansprüche 19 bis 23, wobei die Struktur (3900) ein p-n-Übergang ist.

27. Masterelektrode nach einem der Ansprüche 19 bis 23, wobei die Struktur (3900) ein n-p-Übergang ist.

28. Masterelektrode nach einem der Ansprüche 19 bis 22, wobei die Struktur (22000) einen bipolaren Transistor umfasst, der mindestens einen p-n-Übergang umfasst.

29. Masterelektrode nach einem der Ansprüche 19 bis 22, wobei die Struktur (22000) einen bipolaren Transistor umfasst, der mindestens einen n-p-Übergang umfasst.

30. Masterelektrode nach Anspruch 29, wobei der bipolare Transistor ein p-n-p-Transistor oder n-p-n-Transistor ist.

31. Masterelektrode nach einem der Ansprüche 19 bis 22, wobei die Struktur (12000) eine Isolierschicht (12100) umfasst.

## Revendications

1. Procédé pour procurer une électrode maître ECPR comprenant l'étape dans laquelle :
on procure un élément circulaire (101) faisant office de support possédant une surface d'électrode électroconductrice (106) sur son côté dorsal (104) et un motif topographique (107) définissant plusieurs piles électrochimiques (109) dans l'élément faisant office de support sur son côté frontal (105), chaque pile électrochimique comprenant une paroi latérale (112) et une base (111), dans lequel la surface plane s'étendant entre deux piles électrochimiques adjacentes (109) est recouverte d'une couche (110) procurant une isolation électrique, et dans lequel la base (111) possède une surface électroconductrice (113) reliée de manière conductrice à la surface d'électrode électroconductrice (106) sur le côté dorsal via l'élément faisant office de support,
dans lequel l'étape consistant à procurer ledit motif topographique comprend :
- la passivation d'une partie périphérique du côté frontal de l'élément faisant office de support pour obtenir une zone d'isolation, ladite zone d'isolation (140) entourant une surface circulaire du dispositif ;
- le fait de procurer une couche diélectrique (330) munie de motifs, faisant office de masque dur, sur toute ladite surface du dispositif et sur toute ladite zone d'isolation ; et
- la gravure de l'élément faisant office de support d'une manière telle que l'on obtient lesdites piles électrochimiques à la surface du dispositif, la passivation de la zone d'isolation empêchant en outre la formation de piles électrochimiques par gravure à ladite zone d'isolation.

2. Procédé selon la revendication 1, dans lequel le fait de procurer une couche diélectrique munie de motifs, faisant office de masque dur, sur toute ladite surface du dispositif et sur toute ladite zone d'isolation comprend le fait de procurer plusieurs zones sous la forme de puces rectangulaires, chaque zone sous la forme de puce formant une portion de ladite couche faisant office de masque dur.

3. Procédé selon la revendication 1 ou 2, dans lequel le fait de procurer une couche diélectrique munie de motifs, faisant office de masque dur, sur toute ladite surface du dispositif et sur toute ladite zone d'isolation comprend le fait de recouvrir le côté frontal complet dudit élément faisant office de support avec ladite couche faisant office de masque dur.

4. Procédé selon l'une quelconque des revendications 1 à 3, dans lequel l'étape de passivation d'une partie périphérique dudit côté frontal de l'élément faisant office de support comprend le fait de :
- procurer un masque de gravure par-dessus ladite surface du dispositif ;
- graver le côté frontal de l'élément faisant office de support pour obtenir une zone d'isolation évidée ;
- procurer un masque sélectif d'oxydation par-dessus ladite surface du dispositif ;
- faire croître un oxyde sur ledit côté frontal dudit élément faisant office de support ; et
- retirer ledit masque sélectif d'oxydation de ladite surface du dispositif.

5. Procédé selon la revendication 4, dans lequel ledit masque de gravure est identique audit masque sélectif d'oxydation.

6. Procédé selon la revendication 4 ou 5, comprenant en outre l'étape de passivation d'au moins une paroi latérale sur la portion gravée de la zone d'isolation évidée.

7. Procédé selon l'une quelconque des revendications 4 à 6, dans lequel le fait de procurer le masque de gravure comprend le fait de :
- procurer une première couche de nitrure de silicium (322) par-dessus ladite surface du dispositif ;
- procurer une couche de réserve par-dessus ladite couche de nitrure de silicium ;
- retirer une partie périphérique de ladite couche de réserve ; et
- procéder à une gravure à travers la première couche de nitrure de silicium en utilisant la couche de réserve restante comme masque de gravure.

8. Procédé selon le revendication 7, dans lequel l'étape de gravure à travers la première couche de nitrure de silicium est mise en oeuvre via un procédé anisotrope.

9. Procédé selon l'une quelconque des revendications 1 à 8, comprenant en outre l'étape consistant à procurer un évidement annulaire à ladite partie périphérique.

10. Procédé selon l'une quelconque des revendications 1 à 9, comprenant en outre l'étape consistant à polir ledit côté frontal dudit élément faisant office de support après l'étape de passivation de la partie périphérique, mais avant l'étape consistant à procurer un masque de gravure.

11. Procédé selon l'une quelconque des revendications 1 à 10, comprenant en outre l'étape consistant à procurer une structure d'obstruction ou d'empêchement du courant électrique entre ledit côté frontal et ledit côté dorsal dudit élément faisant office de support.

12. Procédé selon le revendication 11, dans lequel l'étape consistant à procurer une structure d'obstruction ou d'empêchement du courant électrique entre ledit côté frontal et ledit côté dorsal dudit élément faisant office de support comprend le fait de procurer une couche épitaxiale sous la forme d'une couche enfouie (340) dudit élément faisant office de support.

13. Procédé selon le revendication 11, dans lequel l'étape consistant à procurer une structure d'obstruction ou d'empêchement du courant électrique entre ledit côté frontal et ledit côté dorsal dudit élément faisant office de support comprend le fait de procurer un transistor bipolaire sous la forme d'une couche enfouie dudit élément faisant office de support.

14. Procédé selon le revendication 11, dans lequel l'étape consistant à procurer une structure d'obstruction ou d'empêchement du courant électrique entre ledit côté frontal et ledit côté dorsal dudit élément faisant office de support comprend le fait de construire une structure du type silicium-sur-isolant sous la forme d'une couche enfouie dudit élément faisant office de support.

15. Electrode maître ECPR (100, 300) comprenant :
un élément circulaire (101) faisant office de support possédant une surface d'électrode électroconductrice (106) sur son côté dorsal (104) et un motif topographique (107, 307) définissant plusieurs piles électrochimiques (109) dans l'élément faisant office de support sur son côté frontal (105), chaque pile électrochimique comprenant une paroi latérale (112) et une base (111), dans laquelle la surface plane s'étendant entre deux piles électrochimiques adjacentes (109) est recouverte d'une couche (110) procurant une isolation électrique, et dans lequel la base (111) possède une surface électroconductrice (113) reliée de manière conductrice à la surface d'électrode électroconductrice (106) sur le côté dorsal (104) via l'élément faisant office de support (101), dans lequel ledit motif topographique (107, 307) est distribué sur toute une surface circulaire (130, 301) du dispositif comprenant plusieurs zones (103) sous la forme de puces rectangulaires et étant tronquée par une zone (140, 302) soumise à une passivation qui entoure ladite surface (130, 301) du dispositif.

16. Electrode maître ECPR selon la revendication 15, dans laquelle ladite zone (140, 302) soumise à une passivation comprend une couche d'oxyde (315, 326).

17. Electrode maître ECPR selon la revendication 15 ou 16, dans laquelle l'élément (101) faisant office de support comprend un évidement annulaire à l'extérieur de la zone (140, 302) soumise à une passivation.

18. Electrode maître ECPR selon la revendication 17, dans laquelle ledit évidement annulaire s'étend à partir de la périphérie circulaire externe de la zone (140, 302) soumise à une passivation jusqu'au bord de l'élément (101) faisant office de support.

19. Electrode maître ECPR selon l'une quelconque des revendications 15 à 18, comprenant en outre une structure d'obstruction ou d'empêchement du courant électrique (3900, 12000, 22000) entre ledit côté frontal (3200) et ledit côté dorsal.

20. Electrode maître selon la revendication 19, dans laquelle ledit élément faisant office de support est conducteur ou semiconducteur, ladite structure (3900, 12000, 22000) étant conçue sous la forme d'une couche enfouie dudit élément faisant office de support.

21. Electrode maître selon la revendication 19 ou 20, dans laquelle au moins une pile électrochimique parmi lesdites plusieurs piles électrochimiques (3400a-d, 10400a-d) s'étend à travers ladite structure (3900, 12000, 22000).

22. Electrode maître selon l'une quelconque des revendications 19 à 21, dans laquelle ladite structure (3900) comprend une couche épitaxiale procurant une augmentation de la résistance dudit élément faisant office de support.

23. Electrode maître selon la revendication 22, dans laquelle ladite structure (3900) est une couche épitaxiale intrinsèque.

24. Electrode maître selon la revendication 22, dans laquelle ladite structure (3900) est une couche épitaxiale de type p.

25. Electrode maître selon la revendication 24, dans laquelle la couche p-épitaxiale possède un taux de dopage dans la plage de 10¹³ à 10¹⁷ atomes/cm³.

26. Electrode maître selon l'une quelconque des revendications 19 à 23, dans laquelle ladite structure (3900) est une jonction PN.

27. Electrode maître selon l'une quelconque des revendications 19 à 23, dans laquelle ladite structure (3900) est une jonction NP.

28. Electrode maître selon l'une quelconque des revendications 19 à 22, dans laquelle ladite structure (22000) comprend un transistor bipolaire, comprenant au moins une jonction PN.

29. Electrode maître selon l'une quelconque des revendications 19 à 22, dans laquelle ladite structure (22000) comprend un transistor bipolaire, comprenant au moins une jonction NP.

30. Electrode maître selon la revendication 29, dans laquelle ledit transistor bipolaire est un transistor PNP ou un transistor NPN.

31. Electrode maître selon l'une quelconque des revendications 19 à 22, dans laquelle ladite structure (12000) comprend une couche d'isolation (12100).
